# EUROPEAN PATENT SPECIFICATION

(11) **EP 0 852 728 B1**
(45) Date of publication and mention of the grant of the patent: **03.04.2002**
(21) Application number: 96930937.6
(22) Date of filing: 26.09.1996
(51) Int. Cl.: G01R 29/08

(54) **BROADBAND TEM-HORN ANTENNA**
BREITBAND-TEM-HORN-ANTENNE
ANTENNE A LARGE BANDE A CORNET A ONDE ELECTROMAGNETIQUE TRANSVERSE (TEM)

(30) Priority: 26.09.1995 US 4306 P; 21.06.1996 CA 2179703
(43) Date of publication of application: 15.07.1998
(73) Proprietor: PODGORSKI, Andrew S., Ottawa, Ontario K1H 5G6 (CA)
(72) Inventor: PODGORSKI, Andrew S., Ottawa, Ontario K1H 5G6 (CA)
(74) Representative: Loveless, Ian Mark
(86) International application number: CA9600646
(87) International publication number: WO9712252

(56) References cited:
- DE-A- 4 300 778
- US-A- 4 546 358

## Description

This invention relates to compact broadband TEM-horn antennas capable of multi-octave bandwidth and narrow beam operation for communication and high field applications at low, medium and high power levels.

Applicant's PCT application WO 93/03387, published February 18, 1993 teaches a broadband antenna having a similar basic structure.

Some versions of the improved antenna of this application operate at a significantly higher frequency range due to the lack of internal obstructions arising from an unsupported septum and various regions of absorbent material positioned at the mouth of the horn and around the septum.
Figure 1 is a perspective view of one embodiment of the antenna of this invention;
Figures 1A and 1B show different forms of coupling to the antenna;
Figure 2 shows an exploded view of another embodiment of the antenna of this invention;
Figure 3 shows a perspective view of another embodiment of the invention;
Figure 3A shows sectional views of the antenna of Figure 3;
Figure 3B shows a side view of the antenna of Figure 3; Figure 4 shows a signal feed arrangement for the antenna of Figure 3;
Figure 5 shows a perspective view of another embodiment of broadband TEM-horn antenna capable of multi-octave bandwidth and narrow beam operation at frequencies higher than 1 GHz for communication, Electronic Warfare and EMC testing applications at low and medium power levels;
Figure 6 shows the perspective view of the broadband TEM-horn antenna of Figure 5 with one of the horn antenna walls removed in order to show the septum and horn absorbers;
Figure 7 shows a cut through the perspective view of the broadband TEM-horn antenna of Figure 5;
Figure 8 shows a perspective view of another embodiment of the broadband TEM-horn antenna capable of multi-octave bandwidth and narrow beam operation at frequencies higher than 1 GHz for communication, Electronic Warfare and EMC testing applications at high power levels;
Figure 9 shows a perspective view of the broadband TEM-horn antenna of Figure 8 with one of the horn antenna walls removed in order to show the septum and horn absorbers; and
Figure 10 shows a cut through the perspective view of the broadband TEM-horn antenna of Figure 8.

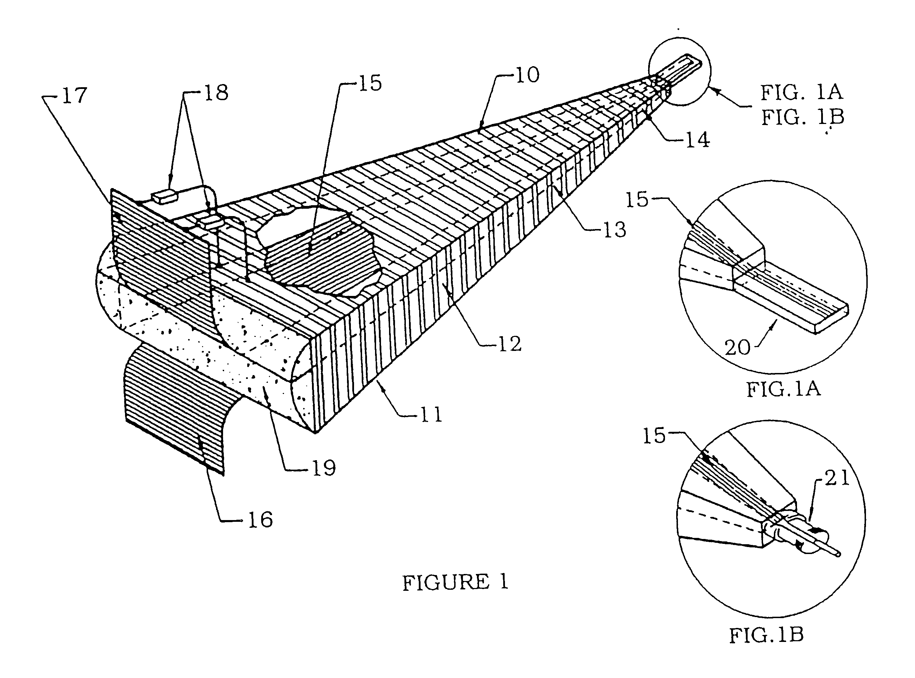

Figure 1 shows an antenna in accordance with the invention consisting of a rectangular horn containing a conducting septum that is located off the geometrical center of the horn. The horn is loaded with dielectric material which at the horn aperture is shaped to form a lens. A pair of forwardly extending plates (septum extension and ground extension) provides a low frequency radiating arrangement and appropriate low frequency termination of the septum. To assure broadband operation of the antenna, the input signals are supplied through striplines or coaxial lines.

Specifically, the antenna consists of two abutting wedge-shaped dielectric members 10 and 11. The side and outer surfaces of each dielectric member are metallized as shown at 12. Member 11 has a wedge angle 13 greater than the wedge angle 14 of member 10. At least one of the abutting inner surfaces of the wedge-shaped members is metallized to form an isolated conductor 15, spaced from the side walls of the horn and functioning as a conducting septum. Due to the unequal wedge angles of members 10 and 11 the septum is asymmetrically positioned in the horn. The curved front surfaces of members 10 and 11 cooperate to provide a lens element to form the horn output into a parallel beam.

A downwardly curved conducting member 16 extends forwardly from the end of the lower conducting surface of the horn and a similar but upwardly curved conducting member 17 extends forwardly from the end of the septum. Terminating resistors 18 connect the free end of member 17 to the upper conducting surface of the horn.

Figures 1A and 1B show alternative structures for connecting power to the antenna. In Figure 1A a stripline 20 is positioned with one conductor connected to an outer conducting surface of the horn and the other conductor connected to the septum 15. In Figure 1B a coaxial line 21 has its central conductor connected to the septum 15 and the outer conductor connected to the outer conducting surface of the horn.

In another embodiment useful for communication at low and medium power levels the antenna can be incorporated into a printed circuit board substrate to provide the septum and the active elements to supply the signal to be transmitted.

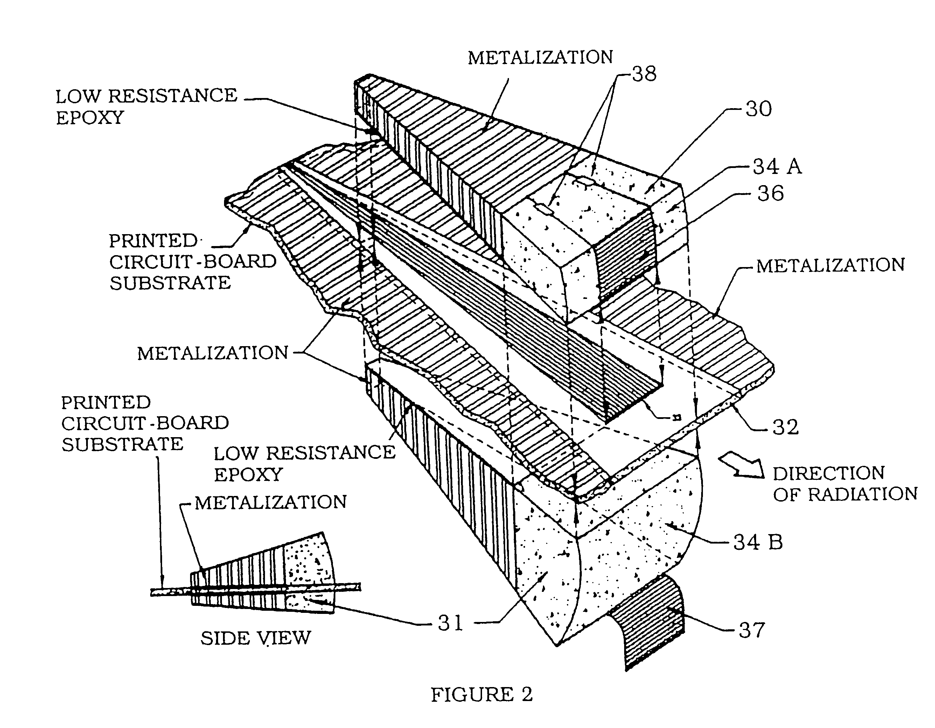

Figure 2 shows the antenna as before formed from two wedge-shaped dielectric members coated on their outer surfaces with conductive material. The dielectric members are sandwiched with a printed circuit board. A pair of forwardly extending plates (septum extension and ground extension) provides a low frequency radiating arrangement and for appropriate low frequency termination of the septum.

Specifically, upper and lower wedge-shaped dielectric members 30 and 31 can be attached by any suitable means, such as epoxy bonding, to opposite sides of a printed circuit board 32. Board 32 contains, in addition to active elements (not shown) a conducting plane 33 which functions as a septum in the antenna. The front surfaces 34a and 34b of members 30 and 31 are curved to cooperate in forming a lens member ensuring that radiation from the antenna is a parallel beam.

A curved conducting extension 35 is connected to and extends upwardly from the end of the septum and is connected to the conducting upper surface of the horn by terminating resistors 36. A further curved, conducting extension 37 is connected to and extends downwardly from the conducting lower surface of the horn.

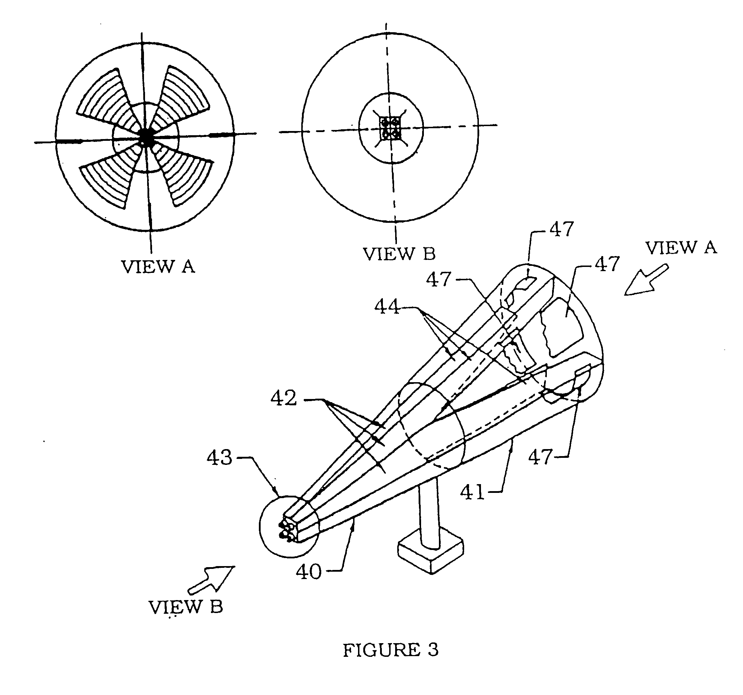

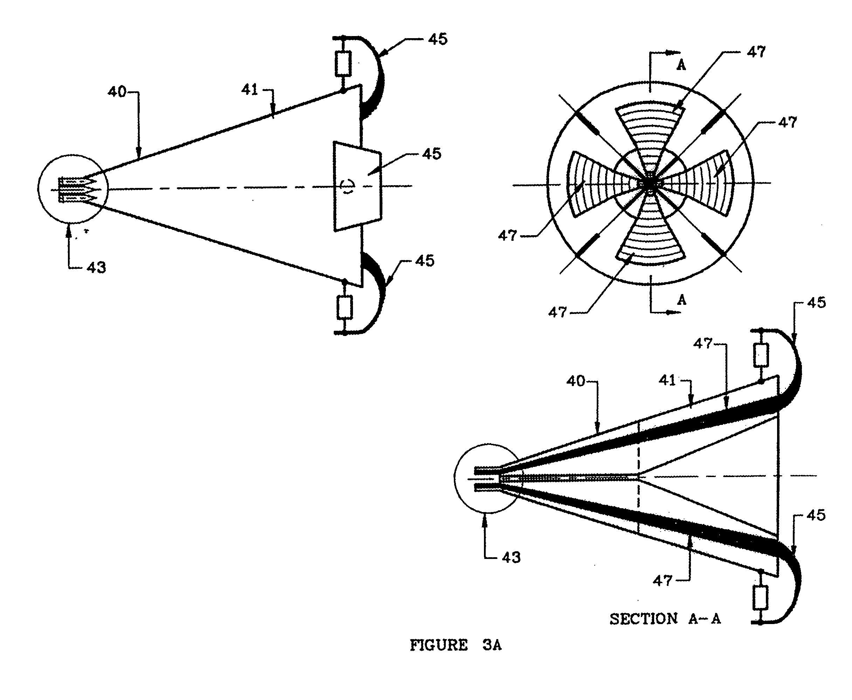

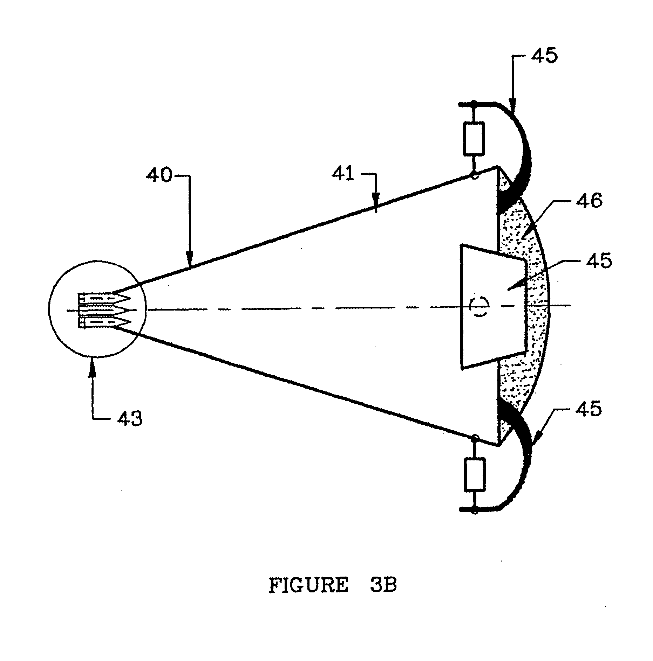

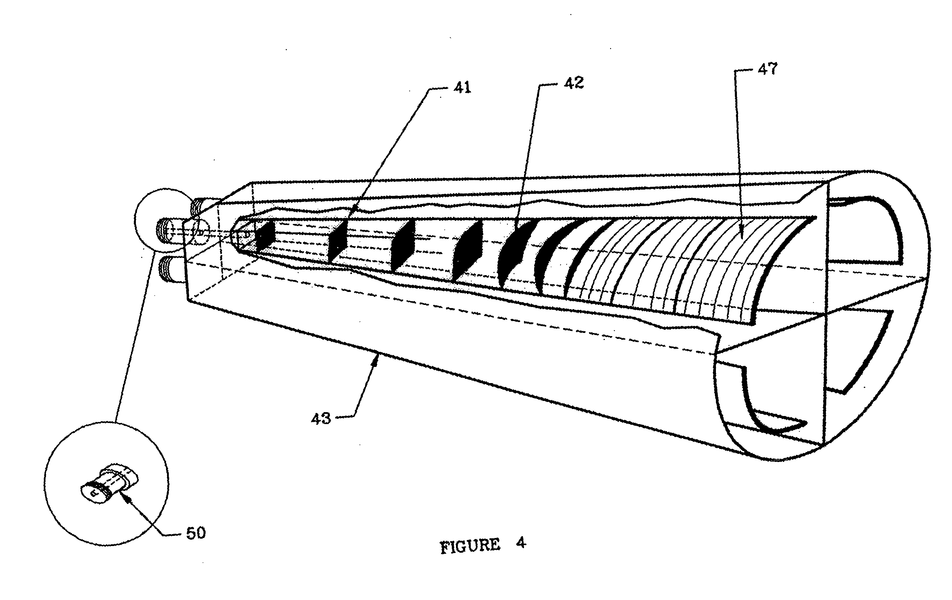

Figure 3 shows another embodiment of the antenna. The overall shape of the horn is conical and it consists of a primary section 40 merging into a secondary section 41. Section 40 is divided into four symmetrical quadrants by interior conducting walls 42. Within each quadrant a conducting conical sector spaced from the outer wall, and spaced from the interior conducting walls, functions as a septum. Throughout the primary section the quadrants are electrically separated from one another and a separate signal feed 43, shown in more detail in Figure 4, is provided for each quadrant.

Section 41 functions to integrate the field components provided by the individual quadrants of section 40. On entering section 41 the septums of each quadrant continue in the same direction and with the same expansion, as shown in fragmentary view at 47. The dividing walls 44 separate to become relatively shorter partitions extending inwardly around the circumference of the horn.

As best shown in Figure 3A, each septum terminates in an outwardly and rearwardly curved extension 45, in turn connected to the conducting outer surface of the horn by matching resistors.

The complete antenna can be filled with dielectric material shaped to form a lens 46 at the horn opening, as shown in Figure 3B.

Figure 4 shows more detail of the signal feed 43 used to connect coaxial lines 50 to the separate quadrants of the primary section 40. The round central pin of each coaxial connector is connected to an elongated element 41. Element 41 has a square cross-section at its junction with the pin and changes in shape along its length through transition shapes 42 (approximately a quadrant of a cone) to merge into the septum of conical sector shape shown at 47. The various cross-sections are shown in black in Figure 4.

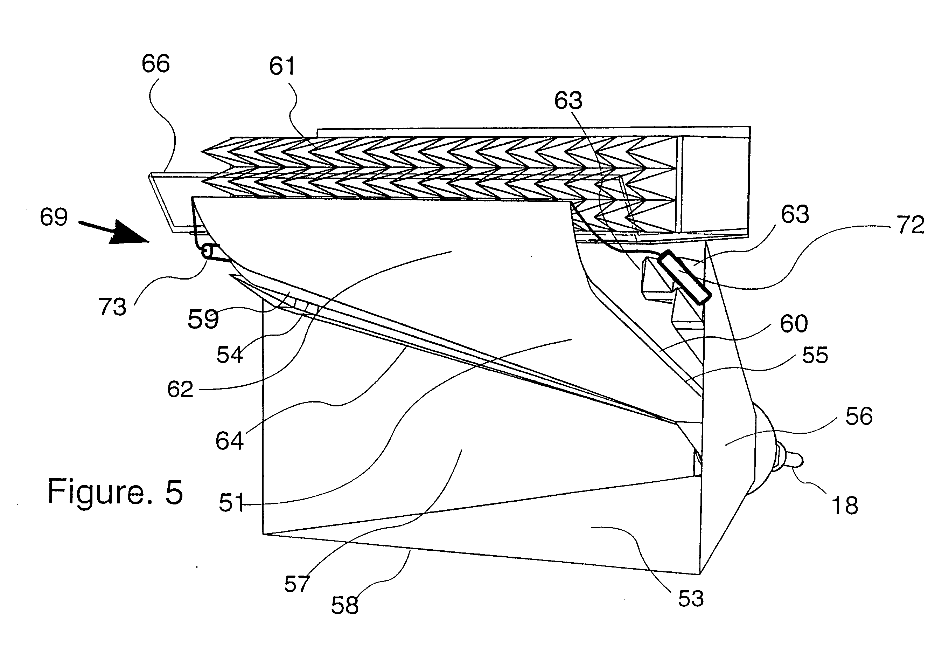

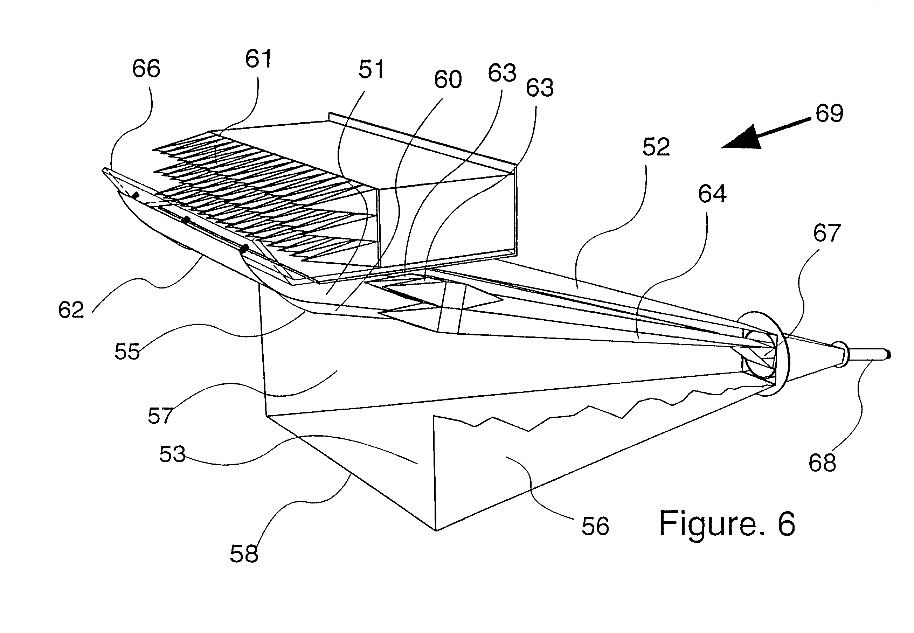

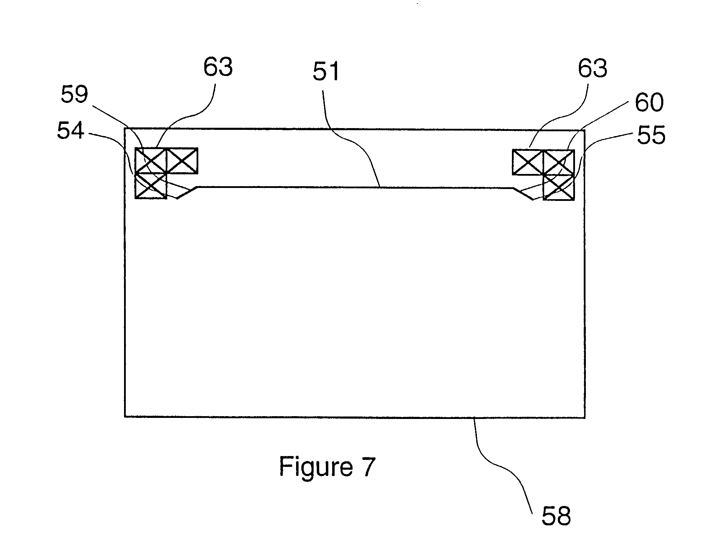

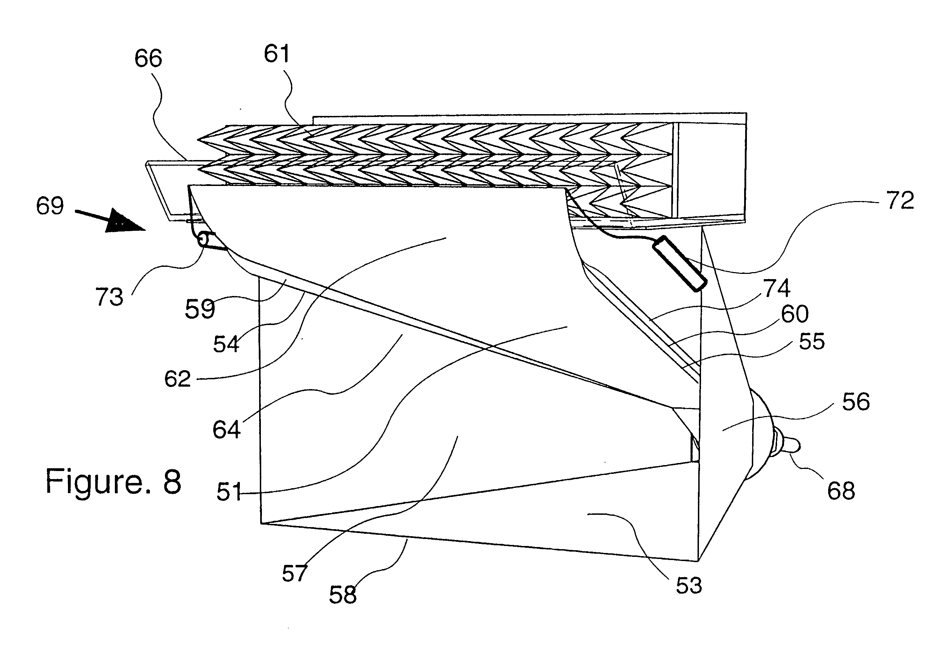

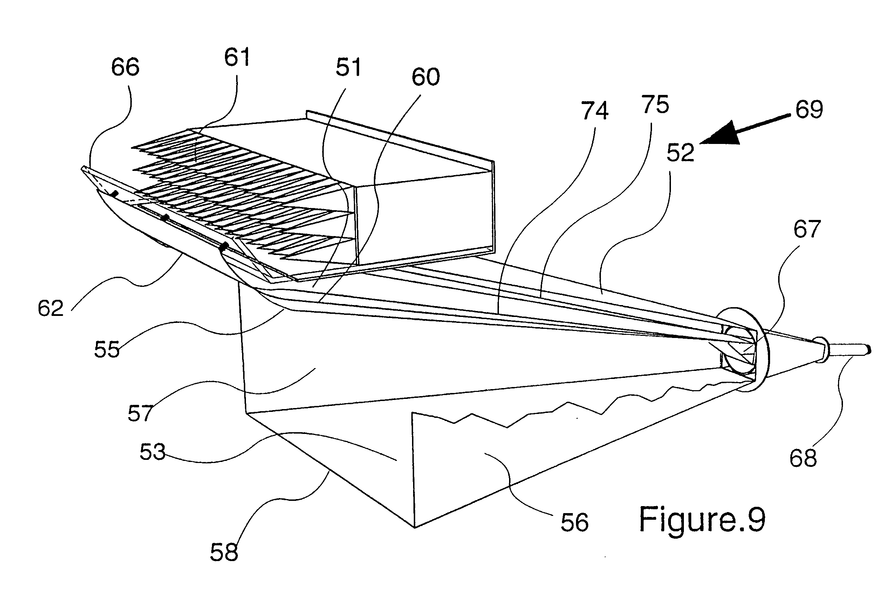

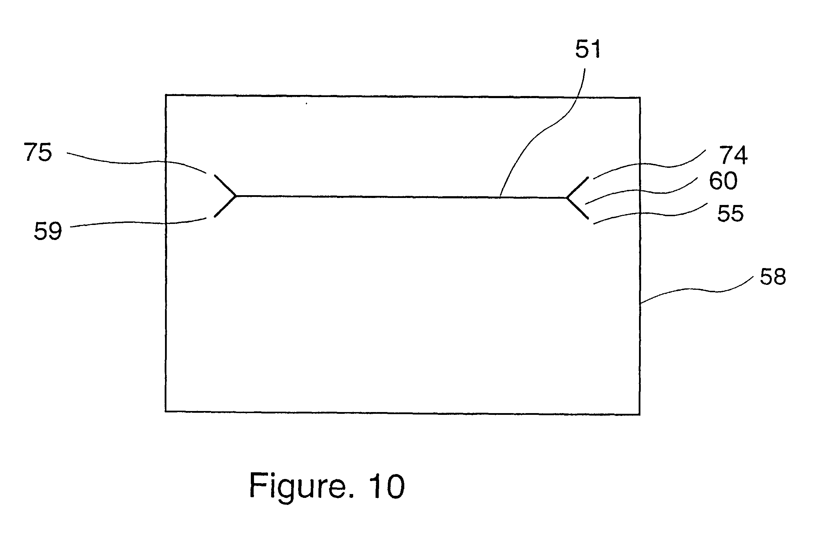

Figure 5 shows a modified embodiment of the antenna of Figure 3. In Figure 5, only one or two segment antennas are used, rather than four as in Figure 3. In Figure 5, the septum (51) of the TEM-horn antenna is straight and as such it has to be supported by dielectric supports inside the horn. For frequencies higher than 1 GHz, due to the interference caused by the dielectric support of the septum (51), the field generated by the antenna is not uniform and it can contain null signals. To avoid this condition, the septum (51) is bent (54 and 55), to provide septum rigidity and to allow the septum to be self-supported at its beginning and end - see Figures 6 and 7. However, bending of the septum results in distortion of the field in the test area. Such field distortion originates at the edges of the bent septum and it can be eliminated through the addition of absorbing material (63,64). Addition of the absorbing material (63,64), results in a limitation to the maximum power handling capabilities of the antenna. To avoid this limitation of maximum power, further modification to the antenna is necessary - see Figure 8. In Figure 8, the absorbers are removed and the rigidity of the septum (51) is assured through an addition of upper (74 and 75) and lower (55 and 59) bends at the edges of the septum (51) - see Figures 9 and 10.

## Claims

1. A compact horn antenna comprising:
two abutting dielectric members (10,11), wedge-shaped in side view with unequal wedge angles (13,14), the front faces of the dielectric members being curved and cooperating with one another to define a lens surface at the front of the horn;
the side and outer surfaces of the dielectric members having conducting coatings;
a conductor (15) sandwiched between abutting inner surfaces of the dielectric members and insulated from other conducting surfaces to form a septum in the horn;
a first downwardly curved conducting member (16) extending forwardly from the front edge of the lower conducting surface of the horn and a second upwardly curved conducting member (17) extending forwardly from the front edge of the septum, the second conducting member being connected to the front edge of the upper conducting surface of the horn by terminating resistors (18).

2. An antenna as set out in claim 1 wherein the conductor (15) sandwiched between the dielectric members is part of a circuit board containing active elements coupled to the conductor.

## Patentansprüche

1. Kompakthornantenne, die folgendes umfasst:
zwei aneinanderstoßende dielektrische Elemente (10, 11), die in Seitenansicht keilförmig mit ungleichen Keilwinkeln (13, 14) sind, wobei die Frontflächen der dielektrischen Elemente gekrümmt sind und so miteinander zusammenwirken, dass sie eine Linsenoberfläche auf der Vorderseite des Horns definieren;
leitende Beschichtungen auf den Seiten- und Außenflächen der dielektrischen Elemente;
einen Leiter (15), der zwischen aneinanderstoßenden Innenflächen der dielektrischen Elemente eingeschlossen und von anderen leitenden Flächen zur Bildung eines Septums in dem Horn isoliert ist;
ein erstes abwärts gekrümmtes leitendes Element (16), das von der Vorderkante der unteren leitenden Fläche des Horns nach vorne verläuft, und ein zweites aufwärts gekrümmtes leitendes Element (17), das von der Vorderkante des Septums nach vorne verläuft, wobei das zweite leitende Element mit der Vorderkante der oberen leitenden Fläche des Horns durch Abschlusswiderstände (18) verbunden ist.

2. Antenne nach Anspruch 1, bei der der zwischen den dielektrischen Elementen eingeschlossene Leiter (15) Teil einer Leiterplatte ist, die mit dem Leiter gekoppelte aktive Elemente enthält.

## Revendications

1. Antenne cornet compacte comprenant :
deux éléments diélectriques jouxtés (10, 11), en forme de coin en vue latérale avec des angles de coin inégaux (13, 14), les faces avant des éléments diélectriques étant courbes et coopérant l'une avec l'autre en vue de définir une surface de lentille à l'avant du cornet ;
les surfaces latérales et externes des éléments diélectriques ayant des revêtements conducteurs ;
un conducteur (15) pris en sandwich entre des surfaces internes jouxtées des éléments diélectriques et isolé des autres surfaces conductrices en vue de former un septum dans le cornet ;
un premier élément conducteur courbé vers le bas (16) s'étendant vers l'avant depuis le bord avant de la surface conductrice inférieure du cornet et un deuxième élément conducteur courbé vers le haut (17) s'étendant vers l'avant depuis le bord avant du septum, le deuxième élément conducteur étant connecté au bord avant de la surface conductrice supérieure du cornet par des résistances de terminaison (18).

2. Antenne selon la revendication 1, dans laquelle le conducteur (15) pris en sandwich entre les éléments diélectriques fait partie d'une carte de circuit contenant des éléments actifs couplés au conducteur.
